# EUROPEAN PATENT SPECIFICATION

(11) **EP 2 684 195 B1**
(45) Date of publication and mention of the grant of the patent: **07.01.2015**
(21) Application number: 12706869.0
(22) Date of filing: 06.03.2012
(51) Int. Cl.: H01B 1/00

(54) **CONDUCTIVE FIBER MATERIALS**
LEITFÄHIGE FASER MATERIALIEN
MATÉRIAUX EN FIBRE CONDUCTRICE

(30) Priority: 07.03.2011 US 201161449744 P
(43) Date of publication of application: 15.01.2014
(73) Proprietor: CNR - Consiglio Nazionale Delle Ricerche, 00185 Roma (IT); Alma Mater Studiorum -Universita' di Bologna, 40126 Bologna (IT)
(72) Inventor: BONFIGLIO, Annalisa, I-09131 Cagliari (IT); FRABONI, Beatrice, I-40136 Bologna (IT); MATTANA, Giorgio, 2000 Neuchâtel (CH)
(74) Representative: Montevecchi, Emma
(86) International application number: PCT/EP2012/053808
(87) International publication number: WO 2012/120006

(56) References cited:
- WO-A1-2010/136720
- US-A1- 2009 137 043

## Description

### Technical field

The present invention relates to a fiber material, in particular a textile which is conductive. The fiber material includes a base textile material on the surface of which a plurality of nanoparticles are deposited and a conductive polymer layer on top of the nanoparticles.

### Background of the invention

Fibers naturally occur in both plants and animals. They are a class of materials that includes continuous filaments or are in discrete elongated pieces, similar to lengths of thread. They can be spun into filaments, string or rope, used as a component of composite materials, or matted into sheets to make products such as paper or felt. Fibers form textiles, which can be woven, non woven, form a knit, a braid or a yarn. Fibers can be categorized in "natural fibers" and "man-made fibers". In the first category lie for example cotton, hair, fur, silk, and wool; while the manufactured "man-made" fibers can be further divided in two sub-categories: regenerated fibers and synthetic fibers. Regenerated fibers are made from natural materials by processing these materials to form a fiber structure. Also called cellulosics, regenerated fibers are derived from the cellulose in cotton and wood pulp. Rayon and acetate are two common regenerated fibers. Synthetic fibers are made entirely from chemicals. The most widely used kinds of synthetic fibers are nylon (polyamide), polyester, acrylic, and olefin.

The concept of "wearable electronics" has emerged in the last 15 years, as a direct consequence of the intensive miniaturization of silicon technology. While in the early years this expression was used in a literal sense to indicate the insertion of small electronic equipment into textile substrates, its meaning has slowly become broader and nowadays it includes any electronic device directly realized in a textile form. A first, simple example of wearable electronics was the fabrication of resistive yarns which were used as electrodes in a system designed to detect electrocardiogram signals (ECG), as shown in D. De Rossi, F. Carpi, F. Lorussi, A. Mazzoldi, R. Paradiso, E. P. Scilingo, A. Tognetti, AUTEX Res. Journal, 2003, 3, 180. More recently, the first example of organic textile active device, namely a field effect transistor, has also been presented in J. B. Lee, V. Subramanian, IEEE Int. El. Devices Meet., 2003, 8, 1 and in M. Maccioni, E. Orgiu, P. Cosseddu, S. Locci, A. Bonfiglio, Appl. Phys. Lett., 2006, 89, 143515. A transistor in textile form is a starting point to the possibility of realizing more complex devices and functions, including the fabrication of whole textile-based circuits. This fact is very important for several reasons: first of all because it allows to overcome problems intrinsically related to the fusion of two very different technologies, like textile and electronics, enabling low cost integration of electronic functions on a normal textile platform; secondly, but not less relevant, because it allows to exploit the topological richness offered by textiles (for instance the ability of obtaining 3D architectures, the possibility of combining different yarns in a unique structure, etc). These possibilities are related to the ability of obtaining yarns that, besides having the required electronic properties, also maintain the mechanical and processing features of a normal fiber.

In the US patent application US 2010/279086 a conductive fabric is provided. The conductive fabric comprises a base layer composed of a synthetic, regenerated or natural fiber, a conductive layer formed on the base layer to be capable of being freely formed by a pre-designed electric pattern, and an insulating layer formed on the conductive layer to protect the conductive layer from damage.

The invention disclosed in the International patent application WO 2010/136720 relates to two variants of a method for producing a multilayer conductive fiber by coating/coagulation, said fiber including: (a) a core made of a natural or synthetic fiber and (b) a sheath containing a vinyl alcohol homo- or copolymer and nanotubes, in particular made of carbon. The invention also relates to the resulting fiber and to the uses thereof. The invention finally relates to a composite material including the abovementioned multilayer composite fibers bonded together by weaving or using a polymer matrix.

The subject matter described in the International patent application WO 2009/070574 relates to the modification of fibers by the growth of films by the Atomic Layer Epitaxy (ALE) process, which is also commonly referred to as Atomic Layer Deposition (ALD). The presently disclosed subject matter relates in particular to a process for the modification of the surface and bulk properties of fiber and textile media, including synthetic polymeric and natural fibers and yarns in woven, knit, and nonwoven form by low-temperature ALD.

Among the materials utilized for textiles and apparel production, cotton (natural cellulose) is indeed the most commonly used material, because of its processing easiness, relative cheapness, good mechanical properties and wearability comfort. Several different methods for the realization of conductive cellulose fibers have already been described in the literature. These procedures may be roughly grouped into two different categories. On one hand, cotton's conductivity was increased by incorporating metal particles or carbon nanotubes (CNTs) into cellulose yarns. With these techniques, very high values of conductance per length unit (up to 1 S cm⁻¹) were achieved. The majority of reported works on conductive cotton, however, have focused on grafting Conductive Polymers (CPs) onto cellulose fibers by in-situ, liquid-phase polymerization, for example in I. Wistrand, R. Lingstrom, L. Wagberg, Eur. Polym. J., 2007, 43, 4075 a sheet of paper has been covered by a conductive polymer, or simple soaking the cellulosic substrates in polymeric aqueous solutions. The most commonly used CPs are π-conjugated polymers including polythiophenes (such as PEDOT i.e. poly(3,4-ethylenedioxythiophene)), polypyrrole and polyaniline. Incorporation of CPs into cotton fibers has shown to raise the conductance per length unit of the native fiber from ∼10⁻¹² to 10⁻² S cm⁻¹. The cellulose-based fibers above described have the following disadvantages: the weight of the fibers is highly increased by the treatments (i.e. 2/3 times their original weight) and moreover they become harder and much less flexible than at the origin, therefore hindering the possibility of using them for creating textile.

### Summary of the invention

The aim of the present invention is the development of a fiber material, preferably but not exclusively an organic fiber material, with the purpose of obtaining conductive fiber materials while preserving the fiber's unique set of physical and comfort properties, i.e. of obtaining a fiber material which is conductive and still having all characteristics of a textile. In addition, another goal of the invention is to realize organic electronic devices produced starting from the aforementioned fiber material treated in order to make it conductive.

The conductive fiber material of the invention includes a base fiber material which is selected among the fibers which are textile fibers, i.e. fibers used to create textile. In the context of the present invention, as textile fiber it is intended a unit in which many complicated textile structures are built up. A textile fiber is suitable for making a fabric or cloth, woven or non-woven. The conductive fiber of the invention is highly conductive when compared to the base fiber material and at the same time it maintains the properties that render the base fiber material a textile fiber. Indeed, the conductive fiber material of the invention is especially adapted for being used in wearable electronics. Preferably, the base fiber material belongs to the class of either natural fibers, which include those produced by plants, animals, and geological processes, or to a sub class of man-made fibers, the regenerated fibers from natural cellulose or the mineral fibers such as fiberglass or carbon fibers. It can additionally include a mixture of the two fibers.

The first group of natural fibers includes as sub categories vegetable fibers, which are generally based on arrangements of cellulose: examples include cotton, hemp, jute, flax, ramie, and sisal. Animal fibers consist largely of particular proteins, possible examples are silk, wool and hair such as cashmere, mohair and angora, fur, etc. Mineral fibers comprise asbestos

Preferably the base fiber material used in the invention includes cellulose, regardless whether it is a natural or a regenerated or a mineral fiber. Even more preferably, the base fiber material of the invention comprises cotton.

The base fiber material of the invention can be a single fiber or can form a textile, i.e. a flexible material consisting of a network of fibers belonging to the above mentioned groups, often referred to as thread or yarn. Yarn is produced by spinning raw fibers to produce long strands. Textiles are formed by weaving, knitting, crocheting, knotting, or pressing fibers together, non woven fabrics are also included. Any network of fibers is therefore included in the present invention. In any case preferably the base fiber of the invention is either a single fiber or a yarn, i.e. it has an elongated structure along one direction, as opposed to a "substrate" which is a plane extended in two directions.

In addition, the conductive fiber material of the invention includes nanoparticles deposited on the external surface of the base fiber material. More preferably, the deposition is substantially uniform. In more details, the nanoparticles form a "layer with holes" i.e. the nanoparticles do not form a continuous layer in which all nanoparticles are in contact with each other, but they present an average distance of 1 nm - 200 nm, however, the deposited nanoparticles have preferably substantially a uniform thickness, which means that when nanoparticles are present on the surface of the base fiber all these "clusters" of local presence have the same height. The "layer with holes" thickness is preferably comprised between 5 nm - 50 nm. The nanoparticles include one or more metal or metal oxide. Preferred metals are those of Groups IV-XII, more preferred those of Groups XI, even more preferred Au and Ag. Examples of metal oxides are ZnO, TiO₂, SnO.

The process of the treatment of the base fiber material in order to deposit the nanoparticles and the deposition of the nanoparticles on the base fiber material is preferably made according to the disclosure of the article H. Dong, J. P. Hinestroza, ACS Appl. Mater. Inter., 2009, 1, 797, more in detail according to the teaching of the patent applications WO 2009/129410 and WO 2010/120531.

However the deposition of the nanoparticles on the surface of the base fiber material can be realized for example using the method disclosed in US 2006/278534. Preferably this deposition is used for non-cellulosic base fiber materials.

Although any method for modifying the surface of the fiber material can be suitably used, such as disclosed in the above WO2009/129410, in a preferred embodiment, before decorating a cellulose-based or a protein-based yarn with nanoparticles, this yarn is conveniently treated to impart a surface charge, preferably a positive charge. Moreover, preferably, the nanoparticles are also charged, so that the attachment of the nanoparticles on the surface of the base fiber material is preferably made via electrostatic bonding.

The nanoparticles have preferably a dimension comprised between 5 nm - 50 nm as determined from TEM images, using the method described in H. Dong, J. P. Hinestroza, ACS Appl. Mater. Inter., 2009, 1, 797. The modification of the base fiber material due to the deposition of the particles is at nanoscale level.

In addition, the conductive fiber material comprises a conductive polymer layer which is deposited on top of the nanoparticles. In particular, the base fiber material on which the nanoparticles have been deposited undergoes a second deposition process, preferably a conformal coating of a conductive polymer. Applicants have found that the presence of two materials, the nanoparticles and a conductive polymer's layer provides a synergistic effect that enhances the conductivity of the modified fiber material by at least one order of magnitude compared to specimens that were merely coated with the conductive polymer or on which only the nanoparticles are deposited.

Preferably, the deposited conductive polymer forms a thin layer, i.e. a layer having a thickness at least thicker of the uniform thickness defined by the "layer with holes" of the nanoparticles, i.e. at least of 50 nm - 100 nm. Most preferably, the conductive polymer layer thickness is comprised between 100 nm and 1 µm. Indeed, the conductive polymer layer should not be too thick in order to avoid an excessive increase of the weight of the fiber material. The polymer layer does not have a uniform thickness, in the sense that the polymer creeps into the base fiber material, i.e. it enters between the nanoparticles (using the holes between them) and the spacing between the fibers themselves. Preferred conductive polymers are comprised in the classes of polythiophenes, polypyrroles and polyacetylenes.

Preferred methods of deposition are those in which the polymer in a vapor phase due to the fact that the preferred method of deposition of the nanoparticles renders the external surface of the base fiber material hydrophobic.

Other methods of deposition can be used. If needed, a preliminary treatment of the fiber material can be done according to the general knowledge in this art. For example, it may be desirable to pre-treat a glass fiber to render it more hydrophilic and this is done according to methods well-known in the art.

Using the teaching of the invention, the resulting conductive fiber material including the nanoparticles and the coating of conductive polymer maintains the typical flexibility of a textile fiber with negligible increase in thickness. Preferably, the total thickness of nanoparticles and polymer coating are of the order of few µm. Applicants have shown that such a fiber material is much more conductive than a fiber material including a base fiber and the nanoparticles or a fiber material including the conductive polymer only.

According to a preferred embodiment of the invention, the conducting fiber materials above realized are further treated with an alcohol or a polyalcohol, such as ethylene glycol. In particular on the conductive polymer a secondary layer, such an as ethylene glycol layer, is added, which chemically modifies the conductive polymer layer and then is evaporated. This addition further increases the conducibility of the base fiber material or of the base fiber material with the conductive polymer coating and the polyalcohol. Moreover, the additional treatment renders the conductive fiber material hydrophobic. Preferably, the conductive fiber material after the deposition of the conductive polymer layer is soaked in the polyalcohol and then the obtained conductive fiber material is baked.

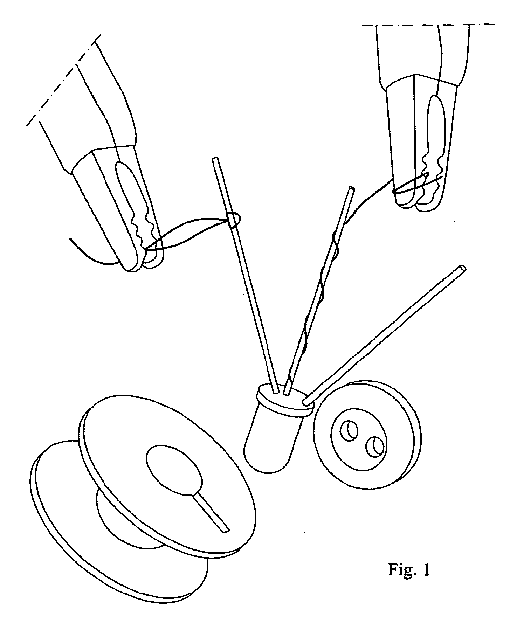

In addition, Applicants have successfully used the conductive fiber material above realized to electrically connect electronic devices, i.e. the conductive fiber materials were sufficiently flexible and conductive to allow a single knot provide an efficient electrical contact between a voltage generator and a LED, which is depicted in the picture appended as fig. 1. The simplicity of the process to create these flexible and conductive fiber materials allows their application in the field of electronic textiles and wearable electronics.

According to a preferred embodiment of the invention, the conductive fiber materials can be used as a source and/or drain and/or gate of a transistor.

Two different kinds of transistors have been realized using the conductive fiber material of the invention: Organic Electro Chemical Transistors (OECTs), whose source, drain and gate contacts are realized by a conductive fiber material (in the preferred embodiment a yarn) made conductive by the treatment described above, and Organic Field Effect Transistors (OFETs) made by a multilayered structure based once again on the above described conductive fiber material, in particular a conductive yarn.

An OECT is made up of two electrodes, source and drain, connected by an active layer called channel realized using a conductive polymer which can be electrochemically doped/de-doped. Applicants have realized the OECT channel by soaking a yarn in a conductive polymer solution (no nanoparticles have been added). In detail, the yarn is made by the base fiber material on which a conductive polymer layer has been deposited and then it has been treated with an alcohol. The obtained modified fiber material is substantially a semi-conductor material the conductivity of which can be changed. The source and/or drain and/or gate of this electrochemical transistor can be realized using the conductive fiber material of the invention. The second example of active device realized using the above mentioned conductive fiber material in form of a yarn is based on the concept of Organic Field Effect Transistor (OFET). In this case, the channel is made by a semiconductor deposited between two metal contacts (source and drain), whose conductivity is modulated by the voltage applied to a gate electrode, capacitively coupled with the device channel. Also in this case, the source and/or drain and/or gate of this electrochemical transistor can be realized using the conductive fiber material of the invention.

The transistor current is modulated by varying the voltage on the gate.

### Brief description of the drawings

The present invention will be better understood by non limiting reference to the appended drawings in which:
- Fig. 1 is a picture of a LED biased using the conductive fiber material of the present invention;
- Fig. 2 is an histogram showing the resistance per unit length values as a function of samples' typology for different fiber materials, among which the conductive fiber material of the invention (last column on the right). The measured voltage drop is referred to 1 cm long samples. For each sample type, ten resistance values were acquired; in the graph, mean values and error bars (standard deviations) are shown;
- Fig. 3 is an histogram analogous to the one of fig. 2 comparing more samples' typology among which the conductive fiber material of the invention;
- Fig. 4 and fig. 5 are a top view and a side view, respectively, of a scheme of an OECT realized using the conductive fiber material of the invention as source and/or drain and/or gate electrodes;
- Fig. 6 is a picture of the transistor of fig. 5 and 6. In this picture, the electrolyte gel block and the semiconductive yarn inside it can be clearly noticed. The source and drain conductive yarns are connected to the semiconductive yarns by means of a knot and can be observed on the sides of the electrolyte gel block. The gate yarn is placed upon the electrolyte block;
- Fig. 7a is a graph showing the gate voltage vs time applied to the device. In this case, drain voltage was kept constant at - 0.5 V while gate voltage varied abruptly from 0 to 1 V (square wave) every 60 seconds;
- Fig. 7b is a graph showing the drain current vs time characteristic as a response to the gate voltage shown in fig 7a;
- Fig. 8 is scheme showing the structure of an OFET fabricated on a conductive fiber material of the invention (for example a cotton yarn);
- Fig. 9 is a graph showing the Id - Vd curves acquired on a cotton-made OFET of fig. 8;
- Fig. 10 shows the various steps of the method of the invention for the fabrication of a conductive fiber material. Fig. 10a depicts the fiber external surface; for example including cellulose hydroxyl groups. Fig. 10b describes the yarn's surface after the treatment before the nanoparticles deposition. Fig. 10c shows the interaction between the fiber surface and the nanoparticles which are well adhered as shown in Fig. 10d. Fig. 10e describes the polymerization process (occurring into a low vacuum vaporization chamber). Fig. 10f shows the yarn's external surface at the end of the process;
- Fig. 11 is a picture of a cross section of a cationic cotton fiber uniformly coated with Au nanoparticles;
- Fig. 12 is a Bright Field TEM image of a cross section of a fiber coated with conductive polymer (PEDOT). The cotton fiber's natural channels are visible on the left of the image while the electronically uniform embedding resin appears on the right. The white layer (and therefore more conductive material) separating the two materials corresponds to the conductive polymer PEDOT. The thickness of the PEDOT layer is not uniform possibly due to the bean-like shape of natural cotton;
- Fig. 13 is a Dark Field TEM image of a cross section of a fiber treated with Au nanoparticles and a conductive layer (PEDOT). The cotton fiber is visible on the left side of the image while the electronically uniform embedding resin appears on the right. The two materials are separated by a grey, conductive layer, which appears darker (and therefore more conductive) in close proximity to the cotton fiber. The rectangle in the conductive layer indicates the area in which the EDS spectrum (see figure 14) was acquired;
- Fig. 14 is a graph showing the EDX analysis performed on the area shown in Fig.13 insert c. The spectrum peaks demonstrate that the conductive layer surrounding the yarn's outer surface is rich in gold (indicative of the presence of Au NP) and sulfur (indicative of PEDOT). This analysis confirms that the conductive layer is actually composed of Au NP and PEDOT:tosylate;
- Fig. 15 is a histogram showing the Young's modulus performing stress - strain tests on the fibers (yarns) of the histogram of fig. 2. For each yarn typology, ten samples (2 cm long) were tested. The graphs show mean values and error bars (standard deviations);
- Fig. 16 is a histogram showing the stress to break of the samples of fig. 2 and 15;
- Fig. 17 is a histogram showing the elongation to break of the samples of figs. 2, 15 and 16;
- Fig. 18 is a graph comparing the stress strain curves of the a plain cotton yarn versus a yarn treated as described in the invention.

### Description of the preferred embodiments

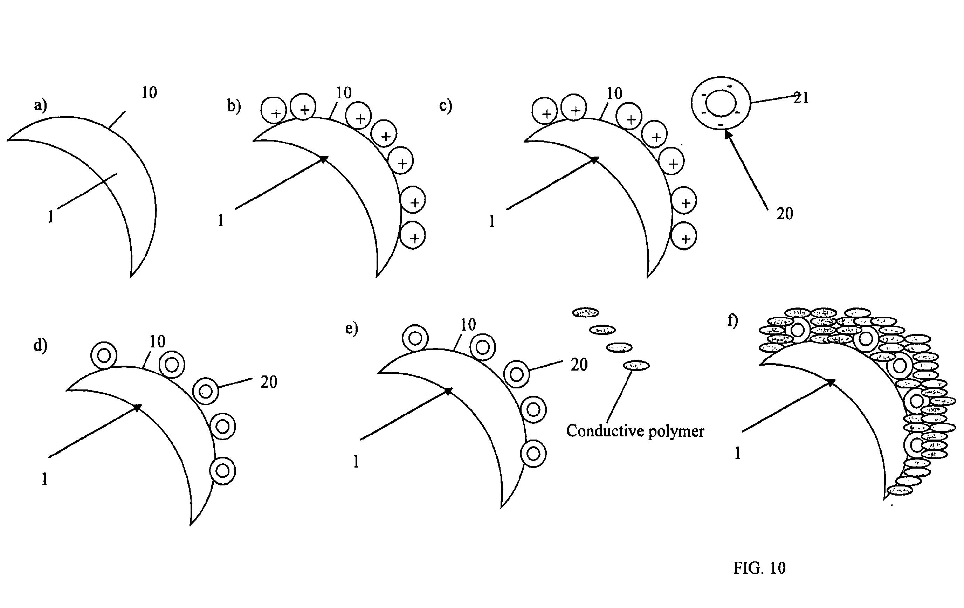

The procedure used to obtain conductive fiber material will be detailed with initial reference to fig. 10. In the following, the initial base fiber material is a yarn, however the fiber material of the invention may include any fibers' network. Moreover, the base fiber material can have any shape, for example can be a round fiber or a flat substrate. Preferably, the base fiber material is a flexible textile yarn elongated along a given direction.

In addition, preferably - but not exclusively - the selected base yarn is a natural yarn, more preferably cotton yarn 1.

The external surface 10 of the yarn 1 is shown in fig. 10a. In case the yarn 1 is a cotton yarn; on the surface of the same the cellulose hydroxyl groups are visible.

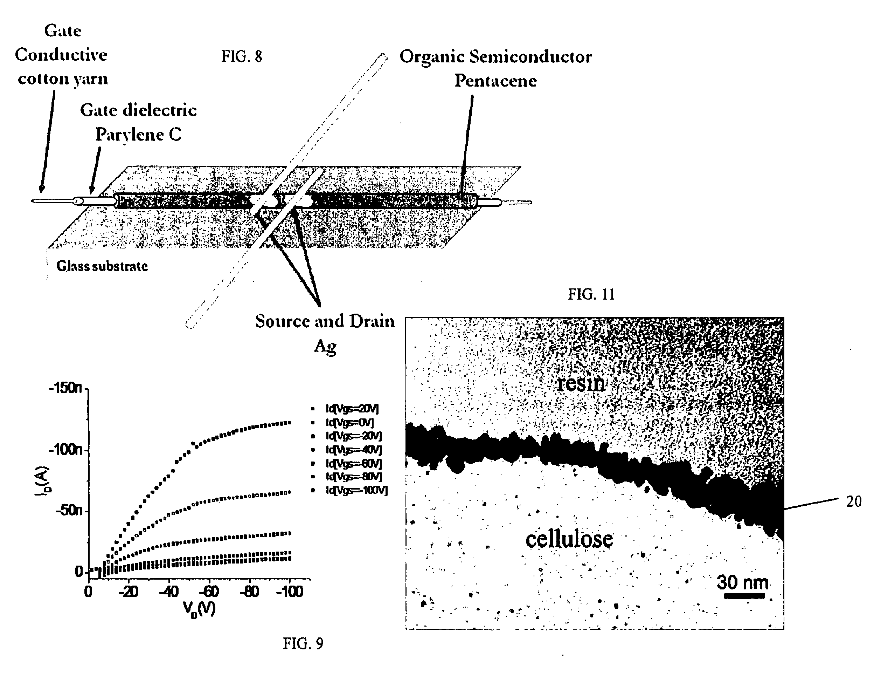

First, the based yarns 1 are treated in order to deposit the nanoparticles on their surface 10. The treatment includes a step of rendering cationic or anionic the base fiber material surface 10. Preferably, if the base fiber material includes cellulose, the fiber material's surface is cationized. Fig. 11b depicts the yarn's surface 10 after the cationization process.

For example, in case the base yarn is a cotton yarn, in the mentioned cationization process the previous hydroxyl groups can be replaced by quaternary ammonium cations so that the yarn's surface is uniformly covered with positive charges.

After this treatment, on the yarn external surface 10 nanoparticles 20 are deposited. The particles, in order to interact with the cations or anions, show on their surface 21 the opposite charge than the one present on the yarn's surface 10. Fig. 10c shows the interaction between the two charges present in the yarns' surface 10 and in the nanoparticles' surface 21: an electrostatic interaction is created and the nanoparticles 20 are trapped on the surface 10 of the base yarn 1 (see fig. 10d).

For example, the nanoparticles 20 can be citrate-coated gold nanoparticles. Since citrate ions, which surround each gold nanoparticle, are negatively charged, and the surface of the cotton is cationized, the development of a strong electrostatic interaction assures their good adhesion to cationized cellulose, as depicted in Fig. 10d. The result is a yarn which is decorated with Au nanoparticles. The details of the procedure are given, as previously mentioned, in the article written by Dong et al and in the two PCT applications.

In a more preferred embodiment, the yarn is chemically treated with a cationizing agent, such as for example an alkyl ammonium salt. Preferred examples are disclosed in the above mentioned WO2009/129410. More preferred are an alkyl ammonium salt of the formula

R₁, R₂, R₃, R₄,N⁺,

wherein:
R₁ comprises a reactive group suitable for functionalizing the primary alcohol of the cellulose backbone, the reactive group is selected from the group consisting of epoxides, C₁-C₄ alkyl iodides/bromide/chlorides, sulfonic acid esters, and activated carboxylic acids, and R₂-R₄ are selected from the group consisting of aliphatic C₁-C₄ carbon chains, optionally being substituted by one or more hydroxyl groups and groups comprising a 5- or 6-membered cyclic ammonium salt.

In another embodiment, the positive charge is provided by using a cationic N-alkylated aromatic heterocycle.

Example of said aromatic heterocycles are: 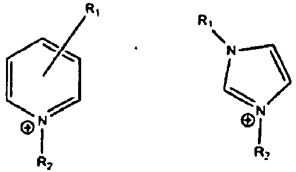 wherein R₁ and R₂ are as defined above. As exemplary embodiment, the cationic N-alkylated aromatic heterocycle is selected from the group consisting of pyridinium and imidazolium.

In another embodiment, the reactive group is selected from the group consisting of epoxides, C₁-C₄ alkyl iodides, C₁-C₄ alkyl bromides, C₁-C₄ alkyl chlorides, sulfonic acid esters, and activated carboxylic acids.

In another embodiment, the positive charge is imparted using a sulfonium salt of the formula

(R₅, R₆ R₇)-S⁺

wherein:
R₅ comprises a reactive group suitable for functionalizing the primary alcohol of the carbohydrate backbone, and R₆ and R₇ are aliphatic C₁-C₄ carbon chains. Examples of reactive group are selected from the group consisting of epoxides, C₁-C₄ alkyl iodides, C₁-C₄ alkyl bromides, C₁-C₄ alkyl chlorides, sulfonic acid esters and activated carboxylic acids. The process for modifying the surface of the cellulose-based or protein-based fiber is a conventional one. In a first step, the fiber is contacted with the cationizing agent. In a preferred embodiment, the fiber material is contacted with a solution, preferably an aqueous solution, of the agent. Soaking time depends on the kind, size and nature of the fiber material and can be easily determined by simple tests. A suitable soaking time is about 30 minutes. Contact temperature can also be easily determined, and is not critical, but may be compatible with the material and stability of the solution. Conveniently, soaking can be performed at a temperature ranging from room temperature to a temperature sufficient to activate the cationization reaction and avoid a too fast evaporation of the reaction medium. Typically, the temperature is below 70°C, for example 60°C. In a second step, after soaking, the fiber material is dried. This step is a conventional one and does not require any special description. Preferably the drying temperature is selected as to avoid any damage to the material.

Methods for preparing metal nanoparticles are well-known in the art, such as disclosed for example in D. L. Feldheim, C. A. Foss, Marcel Dekker Edition, 2002 (ISBN 0824706048).

In a preferred embodiment, gold nanoparticles are prepared according to the well-known citrate method, see J. Turkevich, P.C. Stevenson, J. Hilier, Trans. Faraday Soc. 11 (1951) 55.

Although cotton has been chosen as the fiber composition, any organic fiber can be used in the present invention. Preferably, the fibers include cellulose.

In addition, the nanoparticles can include any metal, not only gold and its compounds. Preferred metals are for example silver.

According to the invention, the following step in the realization of the conductive fiber material of the invention is the deposition of a conductive polymer layer on top of the base fiber material coated with metallic nanoparticles (see fig. 10e). Deposition is made according to the well-known Chemical Vapour Deposition (CVD) technique. Dip coating is an alternative technique.

According to the present invention, a conductive polymer is used. There is virtually no limits on the conductive polymer suitable for the purposes of the present invention, preferably the resistivity of such a polymer is below 100 KΩ/cm. Generally, conductive polymers are well-known in the art. Examples are polymers based on aromatic cycles, such poly(fluorine), polypyirenes, polyazulenes, polynaphthalenes, polypyrroles, polycarbazole, polyindoles, polyazepines, polyanilines, polythiophenes, poly(p-phenylene sulfide). Examples are polymers based conjugated unsaturated bonds, such as polyacetylenes or combinations of aromatic cycles and conjugated unsaturated bonds, such as poly(p-phenylene vinylenes). Preferred polymers are poly(3,4-ethylenedioxythiophene) poly(styrene sulfonate (PEDOT:PSS), poly(4-(2,3-dihydrothieno[3,4-b]-[1,4]dioxin-2-yl-methoxy)-butanesulfonic acid) (PEDOT-S). More preferred polymers are PEDOT:tosylate.

An even more preferred embodiment of the present invention is a cotton yarn, with a layer of gold nanoparticles and made conductive with PEDOT:tosylate. The deposition of PEDOT:tosylate may be performed also on plain cotton yarns.

Conductive polymers are generally well-known in the art, see for example G. Inzelt "Conductive Polymers" Springer 2008.

The deposition process depends on the material chosen for the yarn and on the type of conductive polymer. Preferred examples are for example dip coating in liquid phase or chemical vapour deposition. The thickness of the conductive polymer layer does not need to be uniform as long as the vacancies between nanoparticles are filled by it. Conveniently, polymer thickness can range from about 100 nm to about 1 or 2 µm.

Fig. 10e shows the polymerization process. In the present embodiment the deposition occurs into a low vacuum vaporization chamber where yarns are first soaked in Fe(III):tosytate solution, so that Fe³⁺ ions may act as catalysts for the polymerization of 3,4 - ethylenedioxythiophene (EDOT). When polymerization is complete, the yarns are rinsed in pure ethanol or any other suitable medium so that Fe³⁺ ions are removed. It has to be clear that this is only a specific example of a deposition in the vapor phase, any other deposition technique and conducting polymer can be used as well.

Fig. 10f shows the yarn's external surface at the end of the process. It can be easily noticed the polymeric conductive layer 11, in this case a PEDOT:tosylate layer, that interconnects the metallic nanoparticles previously deposited.

In order to evaluate the conductivity of the obtained conductive fiber material, a comparison has been made by Applicants among the following samples. All samples were electrically characterized with a four-point probe method in order to eliminate possible contributions of contact resistances.
1) Base fiber material without any additional treatment, in this case cotton yarns;
2) Base fiber material covered with conductive polymer, in this case cotton yarn covered by PEDOT:tosylate;
3) Base fiber material covered with metallic nanoparticles, in this case cotton yarn covered by Au nanoparticles;
4) Base fiber material covered with metallic nanoparticles and conductive polymer, i.e. cotton yarn with an Au nanoparticles' layer and subsequently covered with a layer of PEDOT:tosylate (the yarn of the invention).

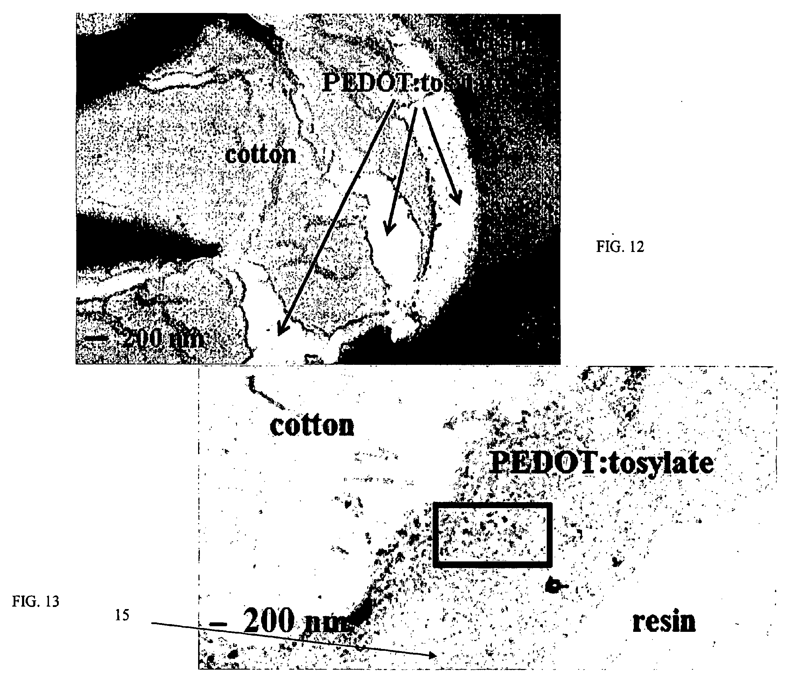

Since a precise determination of the samples' conductive cross section was not possible (see figure 12 for a microscopic analysis of the fibers' cross section), the electrical performance of the different fibers 1 - 4 has been compared in terms of resistance per unit length. In addition a full mechanical characterization was done on all types of yarns.

The 3^{rd} type of fiber material is shown in the cross section of fig. 11 where the cationic cotton fiber uniformly coated with Au nanoparticles is visible.

The 2^{nd} type of fiber material is shown in the Bright Field TEM image of fig. 12, where the cross section of a cotton fiber coated with conductive polymer (PEDOT) is visible. The cotton fiber's natural channels are visible on the left of the image while the electronically uniform embedding resin appears on the right (the resin is used for obtaining the TEM image). The white layer (and therefore more conductive material) separating the two materials corresponds to the conductive polymer PEDOT. The thickness of the PEDOT layer is not uniform possibly due to the bean-like shape of natural cotton.

Gold nanoparticles clearly appear as an external coating (Fig. 11). Conversely, it was found that PEDOT:tosylate is not confined to the yarn's external surface but penetrates among the yarn's inner fibers in a very irregular way (Fig. 12). For this reason, it was not possible to obtain a precise measurement of the samples' cross - sectional conductive area.

The conducting fiber material of the invention, the 4^{th} sample, is visible in the Dark Field TEM image of fig. 13. A cross section of a fiber treated with Au nanoparticles and a conductive layer (PEDOT) is visible. The cotton fiber is visible on the left side of the image while the electronically uniform embedding resin (used to obtain the image) appears on the right. The two materials are separated by a grey, conductive layer 15, which appears darker (and therefore more conductive) in close proximity to the cotton fiber. The rectangle in the conductive layer indicates the area in which a Energy - Dispersive X - ray Spectroscopy (EDS) spectrum was acquired to identify the chemical composition of the materials deposited on the cotton yarn's surface.

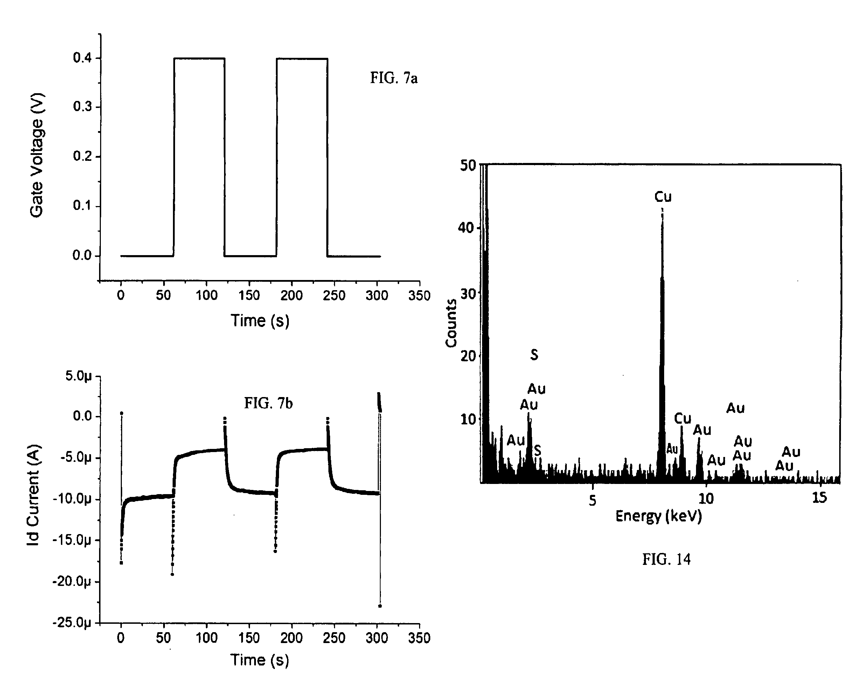

The EDS analysis is depicted in the spectrum of fig. 14. The spectrum peaks demonstrate that the conductive layer surrounding the yarn's outer surface is rich in gold (indicative of the presence of Au NP) and sulfur (indicative of PEDOT, caused by the sulfur atoms contained into the thiophene rings). This analysis confirms that the conductive layer is actually composed of Au NP and PEDOT:tosylate.

The electrical properties of these samples are compared, in order to evaluate the effect on the electrical behavior of the combination of the two deposition processes, namely nanoparticles and conductive polymer on the yarn.

Moreover, it is further shown that the double treatment, i.e. the treatment with Au NPs and PEDOT:tosylate, does not significantly affect the ability of these yarns to be employed in a weaving process, as will be detailed below.

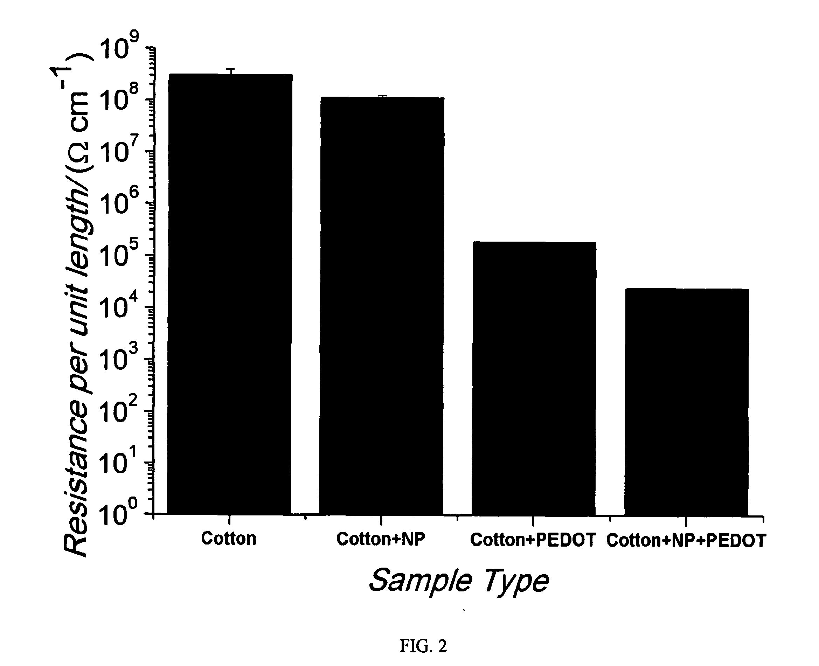

The mean values of the electrical resistance of all samples types are summarized in Fig 2. Resistance per unit length values as a function of samples' typology is measured using the four probe method. The measured voltage drop referred to 1 cm long samples. For each sample type, ten resistance values were acquired; in the graph, mean values and error bars (standard deviations) are shown. High resistance values (3.1 × 10⁸ Ω cm⁻¹) were measured for plain cotton fibers (sample of the 1^{st} type, first column starting from left). Resistance is not significantly decreased by the deposition of Au NP (second column from left, 3^{rd} sample type with nanoparticles). However, the deposition of PEDOT over cotton yarns (third sample from right, 2^{nd} sample type, sample with nanoparticles only) is responsible for a decrease of resistance of three orders of magnitude, with respect to untreated cotton yarns; the resistance of the cotton yarns is further decreased of one order of magnitude when the PEDOT is deposited over cotton fibers conformally coated with Au NP (last column from right, 4^{th} type, the conductive fiber material of the invention).

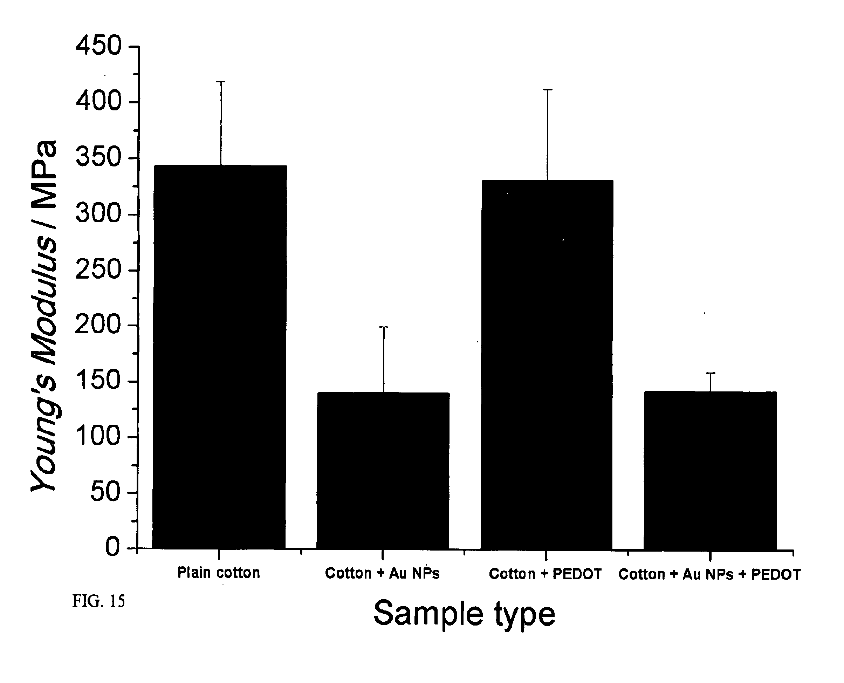

Mechanical parameters were extracted performing stress - strain tests on the samples. For each yarn typology, ten samples (2 cm long) were tested. The graphs shown in figures 15, 16, 17 show mean values and error bars (standard deviations).

Young's modulus was calculated as the slope of stress-strain curve in the linear regime, the stress to break is the stress corresponding to the sample's physical rupture and the elongation to break is the percentage elongation corresponding to the sample's breaking (with respect to the original length, that is 2 cm).

It can be noticed that the deposition of PEDOT:tosylate alone does not affect Young's modulus very much (see fig. 15 comparing the first column from left - 1st sample type - to the third column from left - 2nd sample type), while the mean value of this parameter is reduced of approximately 60% when gold nanoparticles are deposited on the yarns (see fig. 15 second and forth column, which are the 3rd and 4th sample types). The Young's modulus of the conductive fiber material of the invention is therefore substantially similar to the one of the base fiber material on which only the nanoparticles have been deposited.

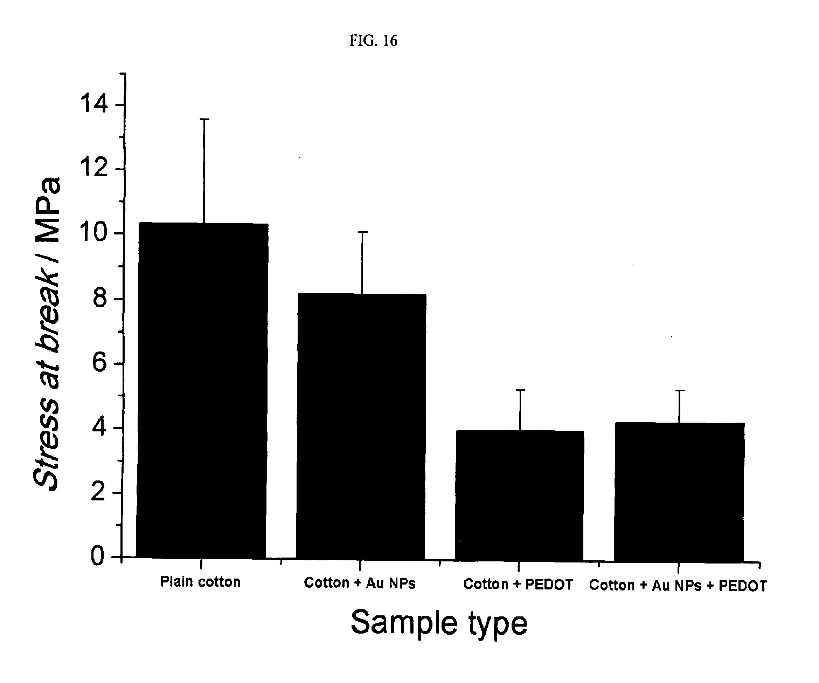

As for the stress at break, it is possible to see from fig. 16 that the treatment with both gold nanoparticles and PEDOT:tosylate decreases the value of this parameter of the 58 % with respect to the value measured for plain cotton yarns. The stress at break of yarns treated with only gold nanoparticles or only PEDOT:tosylate is also lower than the value measured for plain cotton yarns of, respectively, the 20 and 61%.

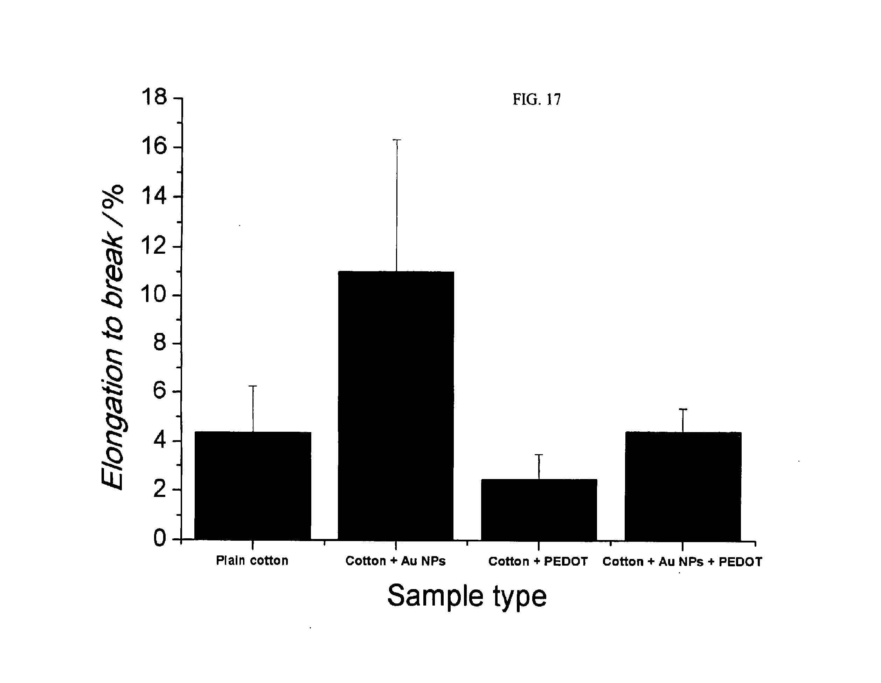

Fig. 17 shows the variations of elongation to break caused by the different treatments. In this case, the yarns which received both the treatments with gold nanoparticles and PEDOT:tosylate have almost the same mean value of elongation to break of plain cotton yarns (4.42 % and 4.36 % respectively). Interestingly enough, when only gold nanoparticles are deposited on cotton yarns the elongation to break increases up to 11.01 % while it is reduced to 2.47 % when only PEDOT:tosylate is deposited on cotton yarns.

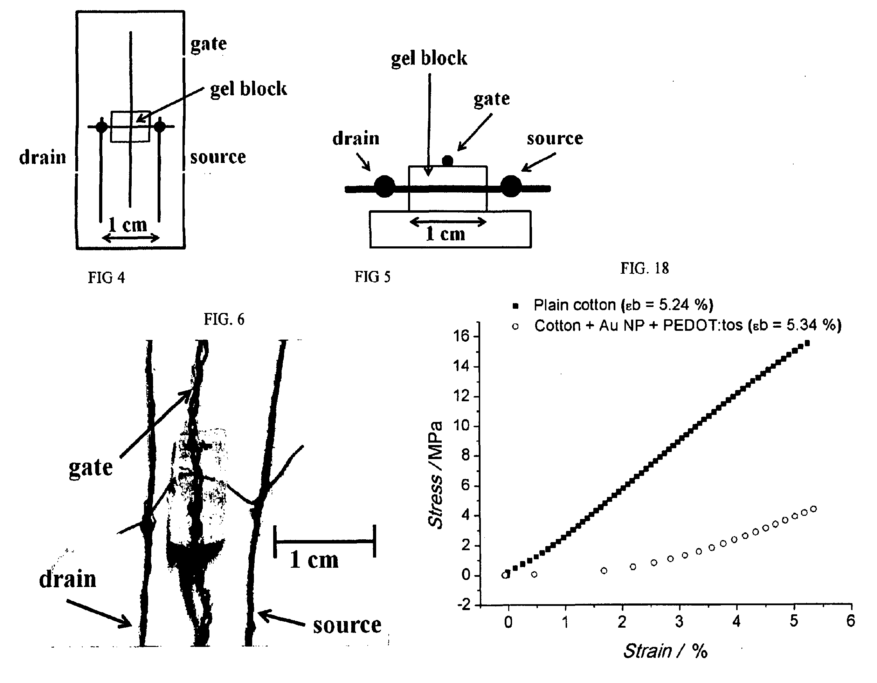

Fig. 18 depicts a typical stress - strain curve of a Au NPs + PEDOT:tosylate yarn compared to a curve acquired on a plain cotton yarn.

Considering the results shown in these figures 15-18, two main observations can be made: first the maximum elongation before breaking appears to be similar for pure cotton and cotton treated with Au NPs and PEDOT:tosylate samples, thus indicating that the main mechanical property of interest for evaluating the ability of the yarn to be woven or knit is preserved in treated yarns. Secondly, as can be observed in fig. 18 the conductive fiber yarn of the invention can reach larger strain values before starting to experience elongational stress. This unusual effect, together with the increase of the elongation to break, that was observed only in nanoparticles-treated samples (with and without PEDOT:tosylate) may be tentatively attributed to a "lubricant" effect due to the nanoparticles coating which seems to enable the yarn inner fibers to slide on one another following the application of the mechanical stimulus. These observations demonstrate therefore that the proposed treatment does not stiffen the cotton yarns.

In summary, the conductive fiber material of the invention maintains the properties of a textile having an increased conductivity.

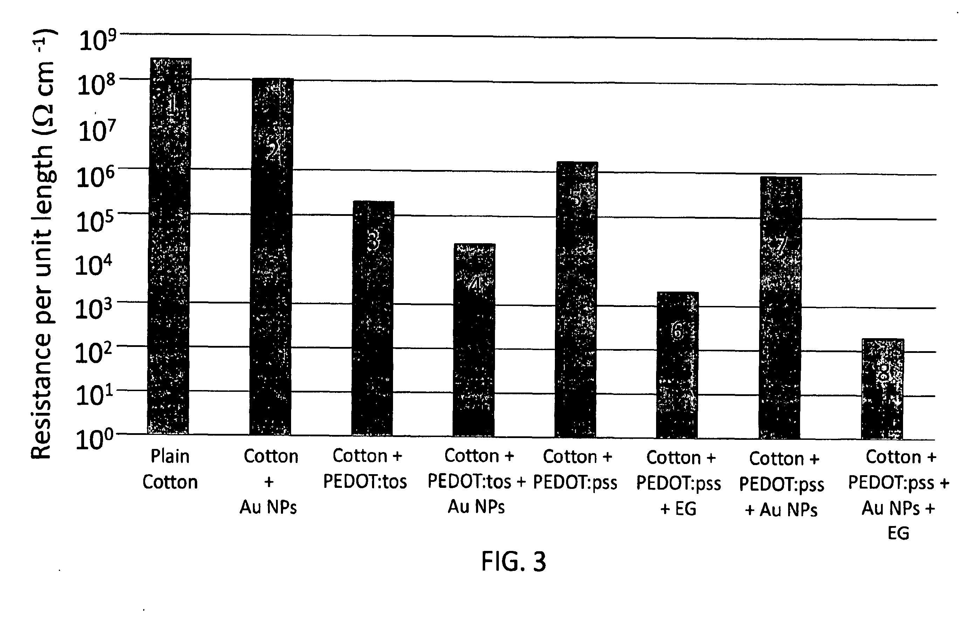

In an additional embodiment of the invention, the conductive fiber material above realized undergoes an additional treatment, in which the outer coating of conductive polymer is treated with a polyalcohol and/or an alcohol. Such an additional treatment further increases the conductivity of the resulting fiber material, as clearly shown in fig. 3 in which the last column (the 8th from left) represents this additional embodiment in which a cotton yarn includes a plurality of Au nanoparticles on its outer surface in turns covered by a layer of PEDOT:PSS. Additionally, this fiber is dipped in polyalcohol and/or an alcohol, such as for example ethylene glycol. The alcohol and or the polyalcohol in excess are subsequently removed, for example by simple evaporation.This fiber material in addition is hydrophobic and it is a semiconductor.

More in detail, the resistivity of the various fibers (such as those depicted in figs. 2 and 3) can be summarized in the following table 1:

**TABLE 1**

| **Fiber material** | **Resistivity** |
|---|---|
| Cotton yarn (1^{st} column from left of figs 2 and 3) | 3.1·10⁸ ± 0.3·10⁸Ω/*cm* |
| Cotton yarn + Gold Nanoparticles (2^{nd} column from left of figs. 2 and 3) | 1.1.10⁸ ± 0.1·10⁸Ω/*cm* |
| Cotton yarn + PEDOT:tosylate (3^{rd} column from left of fig. 2 and 3) | 0.19·10⁶ ± 0.02·10⁶Ω/*cm* |
| Cotton yarn + Gold Nanoparticles + PEDOT:tosylate (4^{th} column from left of figs. 2 and 3) | 24.7·10³ ± 0.3·10³Ω/*cm* |
| Cotton yarn + PEDOT:PSS (5^{th} column from right of fig. 3) | 1.7·10⁶ ± 0.4·10⁶Ω/*cm* |
| Cotton yarn + PEDOT:PSS + ethylene glycol (6^{th} column from right of fig. 3) | 2.2·10³ ± 0.6·10³Ω/*cm* |
| Cotton yarn + Gold Nanoparticles + PEDOT:PSS (7^{th} column from left of fig. 3) | 0.9 · 10⁶ ± 0.3·10⁶Ω/*cm* |
| Cotton yarn + Gold Nanoparticles + PEDOT:PSS + ethylene glycol (8^{th} column from left of fig. 3) | 0.2·10³ ± 0.3·10³Ω/*cm* |

As it is evident from the above table, the combination of the nanoparticles and the conductive polymer layer always increases the conductivity of the base fiber material with respect of the conductivity of the same base fiber material including the same nanoparticles only or the same conductive polymer only. With reference to fig. 3, these differences can be seen comparing column 4 (yarn of the invention, first embodiment) with columns 2 (nanoparticles only) and column 3 (conductive polymer only); or comparing column 7 (yarn of the invention, second embodiment) with column 2 (nanoparticles only) and column 5 (conductive polymer only); or comparing column 8 (yarn of the invention, third embodiment) with column 2 (nanoparticles only) and column 6 (conductive polymer and EG only). In addition, a further increase is obtained using a polyalcohol or alcohol treatment.

To demonstrate the possibility of using the above mentioned conductive fiber material to fabricate organic textiles circuits, two different kinds of transistors have been realized: Organic Electro Chemical Transistors (OECTs), based on a cotton yarn treated with PEDOT:PSS, whose source, drain and gate contacts are realized by a cotton yarn made conductive by the treatment described above, and Organic Field Effect Transistors (OFETs) made by a multilayered structure based once again on a conductive cotton yarn.

An OECT is made up of two electrodes, source and drain, connected by an active layer called channel realized using a conductive polymer which can be electrochemically doped/de-doped.

The channel conductivity is modulated by applying a voltage on a third electrode, the gate, immersed in an electrolyte solution in contact with the channel. The gate voltage drives the electrolyte cations into the channel where they cause its de-doping and, as a consequence, a decrease of the current flowing between the source and drain terminals. Channel de-doping is a reversible process: when the gate voltage is brought back to zero, the channel conductivity again increases.

In the present invention, the OECT channel has been realized by soaking a cotton yarn (the same base fiber material used for the preferred embodiment of the conductive fiber material) in a PEDOT:PSS solution. Normally PEDOT:PSS is soluble in water, and this poses problems for using the yarn as transistor channel. Cotton yarns soaked in PEDOT:PSS have to be put in touch with a water-based electrolyte solution, which causes the dissolution of PEDOT:PSS and therefore the loss of transistor action. To avoid this problem, after the deposition of PEDOT:PSS, the samples were treated with ethylene glycol (EG). The aim of this treatment is twofold: on one hand EG is able to increase the conductivity of PEDOT:PSS, on the other it dramatically decreases its solubility in water.

The deposition of Ethylene Glycole (EG) over previously PEDOT:PSS-treated cotton yarns is responsible for a decrease of resistance of up to three orders of magnitude, with respect to untreated cotton yarns and is not significantly affected by washing in deionized water.

It should be noted that this cotton yarn on which the PEDOT:PSS has been deposited and which then underwent the EG treatment is a semiconductor material and not a conductor material, due to the fact that its conductivity may be modulated by ions when exposed to an electrolytic solution. For this reason, it can be used as the channel layer of the OECT.

The yarn treated with PEDOT:PSS/EG was placed into a small block of electrolyte gel (a potassium chloride aqueous solution solidified by means of a gelling agent). Two conductive cotton yarns, obtained by the previously described treatment with PEDOT:tosylate and Au NPs have then been knit on the yarn treated with PEDOT:PSS/EG, at a distance of 1 cm. These two yarns act as source and drain contacts of the transistor. Finally, a third conductive yarn (cotton fiber coated with Au NPs and subsequently with PEDOT:tosylate), acting as the gate electrode, was placed on the top of the electrolyte block. Fig. 4 and 5 show the scheme and the final assembly of the device. Fig. 7a and 7b shows the electrical characteristics of the obtained device. Despite the non optimal ratio between the on and off currents, the transistor effect is clearly achieved. It should be understood that such a transistor can be realized also when a single source/drain/gate electrode is realized using the conductive fiber material of the invention and the others can be realized using any conductor.

Fig. 6 is an actual picture of the transistor. In this picture it can be clearly noticed the electrolyte gel block and the semiconductive yarn inside it. The source and drain conductive yarns are connected to the semiconductive yarns by means of a knot and can be observed on the sides of the electrolyte gel block. The gate yarn is placed upon the electrolyte block.

The second example of active device realized on a cotton yarn modified according to the invention is based on the concept of Organic Field Effect Transistor (OFET). In this case, the channel is made by a semiconductor deposited between two metal contacts (source and drain), whose conductivity is modulated by the voltage applied to a gate electrode, capacitively coupled with the device channel.

The transistor current is modulated by varying the voltage on the gate. In this case, the yarn-shaped transistor is obtained by means of a multilayered structure based on a conductive core that acts as the gate of the device. This core is made by a cotton yarn treated as described in the invention. The core was then coated with a uniform insulating layer of parylene, followed by the deposition of a pentacene semiconductive layer (see Fig. 8). In this way, a cylindrical capacitor structure is obtained. Finally, source and drain contacts have been deposited at a very short distance on the surface of the pentacene. This cylindrical structure is able to act as a transistor, according to a model that takes into account these geometrical variations giving rise to results very similar to those obtained with planar structures. The only relevant difference is that the width of the channel in this case cannot be larger than the yarn circumference, being source and drain ring-shaped at a short distance (the channel length) apart. This feature severely limits the maximum aspect ratio of the device channel and therefore the maximum current flowing through the device. In Fig. 9 an example of the electrical characteristics of the OFETs is shown, these characteristics that are very similar to typical curves of planar OFETs with comparable aspect ratios.

In this preferred embodiment all source and drain electrodes are realized using the conductive fiber material of the invention, however only one (or two) of those can be realized using such a conductive yarn and the other(s) can be realized using any other conductor. The gate electrode can be a cotton yarn treated with PEDOT:PSS and EG as above described.

The present invention is further illustrated by the following Examples

### Examples

### Preparation of PEDT:PSS coated yarns

The cotton yarns were soaked in an aqueous dispersion of PEDOT:PSS (CLEVIOS^{™} PH 500, H.C. Starck) for 48 hours at 6 °C. Samples were then baked on a hotplate at 145 °C for 60 minutes. After baking, samples were soaked in ethylene glycol (EG) (anhydrous, 99.8 %, Sigma Aldrich) for 3 minutes at room temperature. Then they were baked on a hotplate at 145 °C for 60 minutes. This is the semiconductor yarn.

### Preparation of conductive yarns according to the invention

The procedure for the deposition of Au nanoparticles is described in the already mentioned PCT applications. As a first step, cotton yarns were rendered cationic by soaking them into the following solution: (3-chloro-2-hydroxypropyl)trimethylammonium chloride (CHTAC, 65% solution in water) (100 g) and NaOH (45.5 g) were mixed into deionized water (200 ml). Yarns were firstly dipped in the solution at 50 °C for 30 min then dried at 120°C for 15 min, rinsed with deionized water and dried again at 60 °C for 30 minutes.

The cationic samples were decorated with Au nanoparticles using the following procedure. A solution of hydrogen tetrachloroaurate trihydrate (0.05 g) in deionized water (45 mL) was heated at 90°C for 10 min. A solution of sodium citrate tribasic dihydrate (0.02 g) in deionized water (5 mL) was introduced to the gold salt solution under vigorous stirring and heated for 1 h at 90°C till the solution became uniform wine-red color. Pieces of the cationic cotton yarns were immersed into a beaker containing the solution of Au nanoparticles (50 mL). After 48 h of soaking, the cotton specimens were removed from the container and rinsed thoroughly with deionized water. The coated yarns were then dried in an oven at 60 °C for 30 min.

After conformally coating the cotton yarns with high packing surface density of Au NPs, a solution of 125:25:1 wt% of isopropanol:Fe(III)-tosylate:pyridine was prepared by dissolving Fe(III)-tosylate (0.785 grams) in isopropanol (5 mL) and adding pyridine (32.1 µL) under vigorous stirring. The solution was filtered using a 0.45 µm PTFE filter. The cotton yarns were immersed into a beaker containing the Fe(III):tosylate solution. After 10 minutes of soaking, the yarns were removed from the beaker and dried on a hot plate at 80 °C for 3 min.

A vapor phase polymerization (VPP) chamber was used to polymerize the EDOT into PEDOT. The cotton fibers, after the treatment with Fe(III):tosylate, were placed into the vacuum chamber and kept at 35°C while a crucible containing EDOT (100 µL) was heated up to 80°C. Pressure during polymerization was around 100 Torr. Polymerization time was approximately of 30 minutes.

After polymerization, the samples were dried in an oven at 50 °C for 30 min. Then they were soaked into ethanol for 10 min, in order to remove the iron. The samples were finally dried in a vacuum oven at room temperature for 12 hours.

According to a preferred embodiment, these yarns have been used as source, drain and gate contacts in OECT as shown in figs. 4 and 5.

### Preparation of electrolyte gel

First, a solution of KCl in deionized water (250 mM) was prepared. As a gelling agent, Bacto™ Agar (DIFCO Microbiology) was employed. To prepare the electrolyte gel, the procedure described hereafter was followed: Bacto™ Agar (0.75 g) was dissolved in KCl aqueous solution (20 g, 3.75 % in weight). The solution was heated up at 90 °C and vigorously stirred for 60 minutes. The gel was then poured into a Petri dish and cooled down at room temperature until complete solidification occurred. To improve solidification, the gel was stored at 6 °C for at least 24 hours before being used.

This gel is used in the OECT of figs. 4-6.

### Cotton-based Organic Electro-chemical Transistors assembly:

A piece of semiconductive yarn (1 cm) was inserted into the center of a small parallelepiped of electrolyte gel (approximately: 6 mm³) described above with the help of a needle.

Two conductive yarns (2 cm long) realized according to the invention were fixed at the end of the semiconductive fiber with a simple knot and then connected to the power supply by means of a couple of micrograbbers (see Fig. 6).

Another conductive yarn was fixed on the top of the electrolyte gel block and used as the gate electrode.

### Cotton-based Organic Field Effect Transistors assembly:

The core of the Organic Thin Film Transistors (OTFTs) is a yarn treated with PEDOT:PSS/EG described above, which acts as the gate electrode of the final device. The gate dielectric layer was realized by depositing a thin Parylene C film (nominal thickness 1.5 µm) on the entire yarn surface through a CVD process. After that, a thin pentacene (nominal thickness 50 nm) film was deposited by thermal evaporation at pressure below 2 10⁻⁵mbar, at a constant rate of ca. 4 A min⁻¹. Source and drain electrodes have been realized by depositing two drops of conductive silver paint on the previously realized structure. These drops have been placed by means of a very sharp needle so that a typical channel length of approximately 200 ± 50 µm has been obtained, whereas channel width is usually given by the average circumference of the employed yarn.

### Electrical characterization of OECTs and OFETs:

Each transistor was characterized by acquiring the Ids - Vds curves. The source electrode was grounded while the voltage applied to the drain was:
- varied from 0.5 V to - 0.5 V with steps of - 0.01 V (forward curve) and then again from - 0.5 V to 0.5 V with steps of 0.01 V (backward curve) for OECTs
- varied from 0 V to -60 V with steps of - 1V for OFETs

During the acquisition of each curve, the gate voltage was fixed at a specific value and then increased in correspondence with the acquisition of the next curve (gate voltage range: 0 ÷ 0.4 V, step width: 0.1 V for OECTs; 20 ÷ - 100 V, step width - 10 V for OFETs).

OECT samples were also characterized by the acquisition of drain current vs time curve. In this case, drain voltage was kept constant at - 0.5 V while gate voltage varied abruptly from 0 to 0.4 V (square wave) every 60 seconds.

## Claims

1. A conductive fiber material, said material comprising:
- a base fiber material (1) including a textile fiber;
- a plurality of nanoparticles (20) deposited on an external surface (10) of said base fiber material, said nanoparticles including one or more metals or metal oxides;
- a conductive polymer layer deposited on said external surface including nanoparticles.

2. The conductive fiber material of claim 1, wherein said base fiber material includes cellulose.

3. The conductive fiber material of claim 1, wherein said base fiber material includes cotton.

4. The conductive fiber material of claim 1, wherein said nanoparticles form a layer including empty areas.

5. The conductive fiber material of claim 1, wherein said conductive polymer layer has a thickness larger than the height of said deposited nanoparticles.

6. The conductive fiber material of claim 1, wherein said conductive polymer layer is a polymer coating.

7. The conductive fiber material of claim 6, wherein said polymer layer is formed by dip coating or chemical vapor deposition.

8. The conductive fiber material according to claim 1, wherein said base fiber material is a fiber-based textile.

9. The conductive fiber material according to claim 8, wherein said textile is a yarn, a woven composite, a knit or a braid.

10. A transistor including a source electrode and a gate electrode, said source/drain electrode and/or said gate electrode including a conductive fiber material of claim 1.

11. The transistor of claim 10, wherein said transistor is an organic electro chemical transistor including a channel layer comprising said base fiber material coated with said conductive polymer.

12. The transistor of claim 10, wherein said transistor is an organic field effect transistor.

13. A method for the realization of a conductive fiber based material, said method including the steps of:
- selecting a base fiber material comprising natural fibers and/or cellulosic fibers;
- depositing a plurality of nanoparticles on an external surface of said base fiber material;
- realizing a conductive polymer's layer on said external surfaces including said nanoparticles.

14. Method according to claim 13, wherein said step of depositing said nanoparticles comprises the steps of:
- charging the surface of the base fiber material;
- charging the surface of the nanoparticles;
- attaching the nanoparticles to said surface via electrostatic bonding.

15. The method according to claim 12 or 13, further including the method of
- treating the base fiber including said nanoparticles and said conductive polymer layer with an alcohol or a polyalcohol.

16. The method according to claim 15, wherein said treatment phase includes:
- dipping said base fiber including said nanoparticles and said conductive polymer layer in a solution containing alcohol or polyalcohol;
- evaporating said alcohol or polyalcohol.

## Patentansprüche

1. Leitfähiges Fasermaterial, wobei dieses Material Folgendes umfasst:
- ein Basisfasermaterial (1), das eine Textilfaser umfasst;
- eine Vielzahl von Nanopartikeln (20), die auf eine Außenfläche (10) dieses Basisfasermaterials aufgebracht sind, wobei diese Nanopartikel eines oder mehrere Metalle oder Metalloxide umfassen;
- eine leitfähige Polymerschicht, die auf diese Nanopartikel umfassende Außenfläche aufgebracht ist.

2. Leitfähiges Fasermaterial nach Anspruch 1, wobei das Basisfasermaterial Cellulose umfasst.

3. Leitfähiges Fasermaterial nach Anspruch 1, wobei das Basisfasermaterial Baumwolle umfasst.

4. Leitfähiges Fasermaterial nach Anspruch 1, wobei die Nanopartikel eine Schicht bilden, die leere Bereiche umfasst.

5. Leitfähiges Fasermaterial nach Anspruch 1, wobei die leitfähige Polymerschicht eine Dicke hat, die größer als die Höhe der aufgebrachten Nanopartikel ist.

6. Leitfähiges Fasermaterial nach Anspruch 1, wobei die leitfähige Polymerschicht ein Polymerüberzug ist.

7. Leitfähiges Fasermaterial nach Anspruch 6, wobei die Polymerschicht durch Tauchbeschichtung oder chemische Gasphasenabscheidung ausgebildet ist.

8. Leitfähiges Fasermaterial nach Anspruch 1, wobei das Basisfasermaterial ein faserbasiertes Textil ist.

9. Leitfähiges Fasermaterial nach Anspruch 8, wobei das Textil ein Garn, ein gewebter Verbund, ein Gestrick oder ein Geflecht ist.

10. Transistor, der eine Source-Elektrode und eine Gate-Elektrode umfasst, wobei diese Source/Drain-Elektrode und/oder diese Gate-Elektrode ein leitfähiges Fasermaterial nach Anspruch 1 umfassen.

11. Transistor nach Anspruch 10, wobei dieser Transistor ein organischer elektrochemischer Transistor ist, der eine Kanalschicht umfasst, die das mit dem leitfähigen Polymer überzogene Basisfasermaterial umfasst.

12. Transistor nach Anspruch 10, wobei dieser Transistor ein organischer Feldeffekttransistor ist.

13. Verfahren zur Herstellung eines leitfähigen faserbasierten Materials, wobei dieses Verfahren die folgenden Schritte umfasst:
- Auswählen eines Basisfasermaterials, das Naturfasern und/oder cellulosische Fasern umfasst;
- Aufbringen einer Vielzahl von Nanopartikeln auf einer Außenfläche dieses Basisfasermaterials;
- Herstellen einer Schicht aus einem leitfähigen Polymer auf den die Nanopartikel umfassenden Außenflächen.

14. Verfahren nach Anspruch 13, wobei der Schritt des Aufbringens der Nanopartikel die folgenden Schritte umfasst:
- Aufladen der Oberfläche des Basisfasermaterials;
- Aufladen der Oberfläche der Nanopartikel;
- Anlagern der Nanopartikel an der Oberfläche durch elektrostatisches Bonden.

15. Verfahren nach Anspruch 12 oder 13, das ferner das folgende Verfahren umfasst:
- Behandeln der Basisfaser, welche die Nanopartikel und die leitfähige Polymerschicht umfasst, mit einem Alkohol oder einem Polyalkohol.

16. Verfahren nach Anspruch 15, wobei die Behandlungsphasen Folgendes umfassen:
- Eintauchen der Basisfaser, welche die Nanopartikel und die leitfähige Polymerschicht umfasst, in eine Lösung, die Alkohol oder Polyalkohol enthält;
- Abdampfen des Alkohols oder Polyalkohols.

## Revendications

1. Matériau fibreux conducteur, ledit matériau comprenant :
- un matériau fibreux de base (1) comprenant une fibre textile ;
- une pluralité de nanoparticules (20) déposées sur une surface externe (10) dudit matériau fibreux de base, lesdites nanoparticules comprenant un ou plusieurs métaux ou oxydes métalliques ;
- une couche polymère conductrice déposée sur ladite surface externe comprenant des nanoparticules.

2. Matériau fibreux conducteur selon la revendication 1, dans lequel ledit matériau fibreux de base comprend de la cellulose.

3. Matériau fibreux conducteur selon la revendication 1, dans lequel ledit matériau fibreux de base comprend du coton.

4. Matériau fibreux conducteur selon la revendication 1, dans lequel lesdites nanoparticules forment une couche comprenant des zones vides.

5. Matériau fibreux conducteur selon la revendication 1, dans lequel ladite couche polymère conductrice a une épaisseur supérieure à la hauteur desdites nanoparticules déposées.

6. Matériau fibreux conducteur selon la revendication 1, dans lequel ladite couche polymère conductrice est un revêtement polymère.

7. Matériau fibreux conducteur selon la revendication 6, dans lequel ladite couche polymère est formée par revêtement par immersion ou par dépôt chimique en phase vapeur.

8. Matériau fibreux conducteur selon la revendication 1, dans lequel ledit matériau fibreux de base est un textile à base de fibres.

9. Matériau fibreux conducteur selon la revendication 8, dans lequel ledit textile est un fil, un composé tissé, un tricot ou une tresse.

10. Transistor comprenant une électrode de source et une électrode de grille, ladite électrode de source/drain et/ou ladite électrode de grille comprenant un matériau fibreux conducteur selon la revendication 1.

11. Transistor selon la revendication 10, dans lequel ledit transistor est un transistor électrochimique organique comprenant une couche de canal comprenant ledit matériau fibreux de base revêtu avec ledit polymère conducteur.

12. Transistor selon la revendication 10, dans lequel ledit transistor est un transistor à effet de champ organique.

13. Procédé pour la réalisation d'un matériau conducteur à base de fibres, ledit procédé comprenant les étapes suivantes :
- la sélection d'un matériau fibreux de base comprenant des fibres naturelles et/ou des fibres cellulosiques ;
- le dépôt d'une pluralité de nanoparticules sur une surface externe dudit matériau fibreux de base ;
- la réalisation d'une couche de polymère conducteur sur lesdites surfaces externes comprenant lesdites nanoparticules.

14. Procédé selon la revendication 13, dans lequel ladite étape de dépôt desdites nanoparticules comprend les étapes suivantes :
- la charge de la surface du matériau fibreux de base ;
- la charge de la surface des nanoparticules ;
- la fixation des nanoparticules à ladite surface par liaison électrostatique.

15. Procédé selon la revendication 12 ou 13, comprenant en outre l'étape suivante :
- le traitement de la fibre de base comprenant lesdites nanoparticules et ladite couche polymère conductrice avec un alcool ou un polyalcool.

16. Procédé selon la revendication 15, dans lequel ladite étape de traitement comprend :
- l'immersion de ladite fibre de base comprenant lesdites nanoparticules et ladite couche polymère conductrice dans une solution contenant l'alcool ou le polyalcool ;
- l'évaporation dudit alcool ou polyalcool.
